(19) Europäisches Patentamt
European Patent Office
Office européen des brevets

(11) EP 4 385 799 A1

(12) EUROPÄISCHE PATENTANMELDUNG

(43) Veröffentlichungstag:
19.06.2024 Patentblatt 2024/25

(21) Anmeldenummer: 23215524.2

(22) Anmeldetag: 11.12.2023

(51) Internationale Patentklassifikation (IPC):
B60L 15/20 (2006.01)   B60W 40/12 (2012.01)
G01R 31/00 (2006.01)   G06F 30/15 (2020.01)
B60K 1/00 (2006.01)   B60L 3/00 (2019.01)

(52) Gemeinsame Patentklassifikation (CPC):
B60K 1/00; B60L 3/0084; B60L 15/20;
B60W 40/12; G01R 31/006; G06F 30/15;
G06F 11/3664

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
KH MA MD TN

(30) Priorität: 12.12.2022 DE 102022133024

(71) Anmelder: BPW Bergische Achsen
Kommanditgesellschaft
51674 Wiehl (DE)

(72) Erfinder: Stenkamp, Matthias
51588 Nürnbrecht-Niederbröl (DE)

(74) Vertreter: DREISS Patentanwälte PartG mbB
Friedrichstraße 6
70174 Stuttgart (DE)

(54) SIMULATIONSGERÄT ZUR EINBINDUNG IN EIN FAHRZEUG-BUSSYSTEM EINES ELEKTRISCH ANGETRIEBENEN FAHRZEUGS UND ANTRIEBSSTRANGSTEUERUNG DES ELEKTRISCH ANGETRIEBENEN FAHRZEUGS

(57) Simulationsgerät (10) zur Einbindung in wenigstens ein Fahrzeug-Bussystem (12, 16) eines ein elektrisches Antriebssystem umfassenden Fahrzeugs, insbesondere eines elektrisch angetriebenen Nutzfahrzeugs, und Antriebsstrangsteuerung des elektrisch angetriebenen Fahrzeugs mit einem solchen Simulationsgerät (10), wobei das Simulationsgerät (10) zur Erzeugung von Simulationssignalen derart eingerichtet ist, dass die Simulationssignale
- in Abhängigkeit von Fahrzeug-Ist-Kenngrößen des elektrisch angetriebenen Fahrzeugs erzeugt werden,
- simulierte Kenngrößen eines wenigstens einen Verbrennungsmotor und ein Verbrennungsmotorgetriebe umfassenden verbrennungsmotorischen Antriebsstrang und/oder simulierte Kenngrößen von Komponenten des verbrennungsmotorischen Antriebsstrangs repräsentieren, und
- zur Verarbeitung durch wenigstens ein FAS-Steuergerät eines Fahrerassistenzsystems (FAS) vorgesehen sind.

Fig. 1

EP 4 385 799 A1

**Beschreibung**

Die vorliegende Erfindung betrifft ein Simulationsgerät zur Einbindung in ein Fahrzeug-Bussystem eines elektrisch angetriebenen Fahrzeugs und eine Antriebsstrangsteuerung des elektrisch angetriebenen Fahrzeugs.

Fahrerassistenzsysteme (FAS) sind elektronische Zusatzeinrichtungen in Kraftfahrzeugen zur Unterstützung des Fahrers in bestimmten Fahrsituationen. Hierbei stehen oft Sicherheitsaspekte, aber auch die Steigerung des Fahrkomforts im Vordergrund. Ein weiterer Aspekt ist die Verbesserung der Wirtschaftlichkeit.

Die Fahraufgabe wird im weitesten Sinne in die drei Ebenen der Planung, Führung und Stabilisierung eingeteilt. Für die Führungs- und Stabilisierungsebenen sind meistens nur Handlungszeiträume von (Milli-)Sekunden verfügbar, die nur mithilfe von Fahrdynamiksystemen erreicht werden können, da diese die Handlungsfähigkeiten des Menschen bei weitem übertreffen.

FAS, wie beispielsweise ABS (Antiblockiersystem) und ESP (elektronisches Stabilitätsprogramm), sind standardmäßig in den meisten Fahrzeugen vorhanden bzw. sind bei Neufahrzeugen gesetzlich vorgeschrieben. Bisher war der Großteil der Fahrzeuge mit einem verbrennungsmotorischen Antriebsstrang ausgerüstet. Der elektrische Antriebsstrang gewinnt zunehmend an Bedeutung. Die meisten FAS sind bisher für den Einsatz mit verbrennungsmotorischen Antriebssträngen entwickelt und optimiert, elektrische Antriebsstränge bringen neue Voraussetzungen mit sich. Der Einsatz von bisherigen FAS in elektrisch angetriebenen Fahrzeugen ist nicht ohne weiteres möglich und stellt die FAS-Entwicklung vor neue Herausforderungen.

Die Aufgabe der vorliegenden Erfindung besteht darin FAS für ein elektrisch angetriebenes Fahrzeug bereitzustellen.

Die Aufgabe wird durch ein Simulationsgerät zur Einbindung in wenigstens ein Fahrzeugbussystem eines ein elektrisches Antriebssystem umfassenden Fahrzeugs nach Anspruch 1 gelöst. Das Simulationsgerät ist zur Erzeugung von Simulationssignalen derart eingerichtet, dass die Simulationssignale in Abhängigkeit von Fahrzeug-Ist-Kenngrößen des elektrisch angetriebenen Fahrzeugs erzeugt werden. Weiterhin repräsentieren die Simulationssignale simulierte Kenngrößen eines wenigstens einen Verbrennungsmotor und ein Verbrennungsmotorgetriebe umfassenden verbrennungsmotorischen Antriebsstrang und/oder simulierte Kenngrößen von Komponenten des verbrennungsmotorischen Antriebsstrangs. Die erzeugten Simulationssignale sind zur Verarbeitung durch wenigstens ein FAS-Steuergerät eines Fahrerssistenzsystems (FAS) vorgesehen. Das FAS kann beispielsweise aber nicht abschließend ESP, ABS und AEBS (Advanced Emergency Braking System) sein. Auch für neuere komplexe FAS-Systeme für das autonome Fahren, sogenannte ADAS (Advanced Driver Assistance Systems), können Simulationssignale durch das Simulationsgerät bereitgestellt werden.

Das erfindungsgemäße Simulationsgerät ermöglicht, dass die sicherheits- und zulassungsrelevanten FAS und/oder ADAS ohne Änderungen oder mit nur kleinen Änderungen aus bisherigen verbrennungsmotorisch angetriebenen Fahrzeugen in elektrisch angetriebenen Fahrzeugen eingesetzt werden können, insbesondere bei einem Umbau des Antriebsstrangs stellt das Simulationsgerät eine Möglichkeit bereit, bisherige FAS weiterhin zu nutzen. Die Entwicklung von FAS bis zur Zulassung ist kostenaufwendig und mit hohem Zeitaufwand verbunden. Bisherige FAS sind meist für verbrennungsmotorisch angetriebene Fahrzeuge erprobt und sind nicht geeignet für neue, elektrisch angetriebene Fahrzeuge, in diesem Fall schafft das erfindungsgemäße Simulationsgerät Abhilfe um FAS in Form der bisherigen FAS zu nutzen. Dies kann hohe Entwicklungskosten einsparen und die Entwicklungszeit eines elektrisch angetriebenen Fahrzeugs zur Marktreife reduzieren. FAS müssen mit einer Vielzahl von Signalen und Informationen versorgt werden. Meist ist das FAS-Steuergerät über ein Fahrzeug-Bussystem mit weiteren Steuergeräten des Antriebsstrangs vernetzt und greifen von dort auch Signale des Antriebsstrangs und weitere Komponenten zurück. Ein elektrischer Antriebsstrang weist Unterschiede zu einem verbrennungsmotorischen Antriebsstrang auf, verschiedene Steuergeräte, Komponenten und Signale fehlen oder unterscheiden sich stark. FAS, welche ursprünglich für einen verbrennungsmotorischen Antriebsstrang vorgesehen sind benötigen für eine ordnungsgemäße Funktion gewisse Signale oder Reaktionen des Fahrzeugs. Bei einem Wechsel des Antriebsstrangs fehlen diese Signale und eine ordnungsgemäße Funktion des FAS kann nicht gewährleistet werden.

Das erfindungsgemäße Simulationsgerät stellt den ursprünglich für ein verbrennungsmotorischen Antriebsstrang umfassendes Fahrzeug - Originalfahrzeug - vorgesehenen FAS-Steuergeräten über eine Kommunikationsschnittstelle geeignete Signale, beispielsweise in einem CAN-Bus (Controller Area Network), zur Verfügung, die im Originalfahrzeug von Steuergeräten stammen, welche im Elektrofahrzeug nicht mehr vorhanden sind. Dies kann auch als eine Art Restbussimulation bezeichnet werden.

Beispielsweise werden fiktive Schaltvorgänge eines nicht vorhandenen Schaltgetriebes simuliert sowie daraus folgende Drehzahlschwankungen, die dem Verhalten des Originalfahrzeugs entsprechen und entsprechende Simulationssignale bereitgestellt. Auf diese Weise ist für die FAS keine Veränderung im Kommunikationsnetzwerk erkennbar.

Darüber hinaus werden die von den FAS ausgesendeten Nachrichten so verarbeitet, dass die Reaktion auf diese Nachrichten dem Originalfahrzeug entspricht. Dies ist beispielsweise die graduelle Reduktion des Antriebsmoments als Reaktion auf eine Intervention des Elektronischen Stabilitätsprogramms (ESP) oder des Notbremsassistenten (AEBS).

Das Simulationsgerät ist vorzugsweise derart eingerichtet, dass es als Fahrzeug-Ist-Kenngrößen Signale und Kenngrößen verarbeitet. Diese Signale und Kenngrößen repräsentieren eine Größe der Räder des elektrisch angetriebenen Fahrzeugs, eine Geschwindigkeit des elektrisch angetriebenen Fahrzeugs, eine Drehgeschwindigkeit der Räder des elektrisch angetriebenen Fahrzeugs, eine Drehzahl des elektrischen Antriebsystems, ein Drehmoment des elektrischen Antriebsystems, und/oder Leistungsaufnahme des elektrischen Antriebsystems. Die Größe der Räder kann der Umfang der Räder sein. Die Drehzahl des elektrischen Antriebsystems kann die Drehzahl eines oder mehrerer elektrischer Maschinen, sowie die Eingangs- und/oder Ausgangsdrehzahl einer Getriebeeinheit sein. Die Leistungsaufnahme des elektrischen Antriebssystems kann auch durch Berechnung aus der Batteriespannung und der Stromaufnahme des Antriebssystems ermittelt werden. Durch die Einbeziehung von gemessenen oder bestimmten Fahrzeug-Ist-Kenngrößen können genaue Simulationssignale bereitgestellt werden, um eine sichere Funktion des FAS in der aktuellen Fahrsituation zu gewährleisten.

Das Simulationsgerät ist weiter vorzugsweise derart eingerichtet, dass die simulierten Kenngrößen der Simulationssignale eine simulierte Motordrehzahl des Verbrennungsmotors, eine simulierte Getriebestufe des Verbrennungsmotorgetriebes, ein simuliertes Motordrehmoment des Verbrennungsmotors und/oder ein simuliertes Ausgangsdrehmoment des vom Verbrennungsmotor angetriebenen Antriebsstrangs repräsentieren.

Es ist denkbar, dass das Simulationsgerät derart eingerichtet ist, dass die simulierten Kenngrößen auch in Abhängigkeit von FAS-Signalen, die von den wenigstens einen FAS erzeugt wurden, erzeugt werden. Dies hat den Vorteil, dass die Reaktion des simulierten verbrennungsmotorischen Antriebsstrangs auf einen Regeleingriff des FAS mit in die Simulation einfließt und so das FAS weiter verbessert werden kann.

Bevorzugt ist das Simulationsgerät derart eingerichtet, dass es als Fahrzeug-Ist-Kenngrößen auch Signale und Kenngrößen verarbeitet, die die jeweilige Pedalstellung des Fahrpedals des Fahrers repräsentieren, und wobei als Simulationssignal auch eine Kenngröße erzeugt wird, die ein simuliertes Fahrerwunschmoment des Verbrennungsmotors oder des verbrennungsmotorischen Antriebsstrangs repräsentiert. Der Fahrer teilt einem Antriebsstrang sein Fahrerwunschmoment über ein Fahrpedal mit. Das Fahrerwunschmoment des Verbrennungsmotors oder verbrennungsmotorischen Antriebsstrangs unterscheidet sich von dem des elektrischen Antriebsstrangs, deshalb ist es vorteilhaft, wenn ein simuliertes Fahrerwunschmoment bereitgestellt wird.

Das Simulationsgerät kann eine Schnittstelle zur Einbindung in wenigstens ein Fahrzeug-Bussystem aufweisen. Weiter könnte das Simulationsgerät derart eingerichtet sein, dass das Simulationsgerät über die Schnittstelle die Fahrzeug Ist-Kenngrößen (auch FAS-Signale) empfängt und die Simulationssignale an das FAS-Steuergerät sendet. Die Schnittstelle kann gleichzeitig in mehreren Bus-Systemen eingebunden sein, um auf verschiedene Signale zugreifen zu können. Die Bus-Systeme können gleichartig wie beispielsweise mehrere CAN-Bus Netzwerke oder verschieden wie beispielswese CAN, Flex-Ray, Automotive-Ethernet oder LIN sein. Es ist ferner denkbar, dass die Schnittstelle eine Möglichkeit zur Verbindung des Simulationsgeräts an weitere Peripheriegeräte, sowie Diagnosemöglichkeiten in Form eines externen Rechners, bietet. Weiterhin kann die Schnittstelle einen Signalaustausch zwischen verschiedenen Bus-Systemen ermöglichen. Ferner ist denkbar, dass das Simulationsgerät in einem FAS-Steuergerät integriert ist.

Bevorzugt umfasst das Simulationsgerät einen Speicher, in dem Kenngrößen und/oder Kennfelder des verbrennungsmotorischen Antriebsstrangs und/oder von dessen Komponenten hinterlegt sind. Weiterhin ist denkbar, dass die Simulationssignale auch in Abhängigkeit der Kenngrößen und/oder Kennfelder erzeugt werden. Der sichere und ordnungsgemäße Betrieb der FAS erfordert möglichst präzise Daten im Falle einer Restbussimulation mit den Simulationssignalen, daher ist es vorteilhaft, wenn die Simulationssignale aus einem spezifischen Datensatz aus Kenngrößen und Kennfeldern des verbrennungsmotorischen Antriebsstrangs erzeugt werden.

Vorteilhafterweise ist das Simulationsgerät weiter derart eingerichtet, dass aus der jeweiligen Fahrzeuggeschwindigkeit eine simulierte Getriebestufe des Verbrennungsmotorgetriebes bestimmt wird. Elektrische Antriebssysteme haben üblicherweise keine schaltbaren Getriebestufen. Der Wechsel zwischen den Getriebestufen hat Drehmomentsprünge des Ausgangsdrehmoments und Drehzahlveränderungen zur Folge, welche im elektrischen Antriebsstrang des Fahrzeugs nicht vorhanden sind.

Das Simulationsgerät ist vorheilhafterweise weiter derart eingerichtet, dass aus der jeweiligen Fahrzeuggeschwindigkeit und der jeweils bestimmten simulierten Getriebestufe eine simulierte Drehzahl des Verbrennungsmotors bestimmt wird. Die Drehzahl des Verbrennungsmotors ist dabei vorzugsweise auf einen Bereich zwischen einer minimalen Drehzahl und maximalen Drehzahl begrenzt. Die minimale Drehzahl entspricht dabei der Leerlaufdrehzahl, die maximale Drehzahl der zulässigen Höchstdrehzahl, des simulierten Verbrennungsmotors. Die Drehzahlen können dabei als Kenngrößen im Speicher des Simulationsgerätes abgelegt sein, oder aus einem im Speicher abgelegten Kennfeld abgeleitet werden.

Es ist denkbar, dass das Simulationsgerät weiter derart eingerichtet ist, dass dann, wenn ein Wechsel der Getriebestufte simuliert wird, die simulierte Drehzahl für einen vorgegebenen Zeitraum eine minimale Drehzahl repräsentiert. Dadurch wird das Verhalten des verbrennungsmotorischen Antriebsstrangs genau simuliert und entsprechende Signale bereitgestellt, da der Wechsel der Getriebestufen einen Zeitraum benötigt in dem kein Drehmoment vom Verbrennungsmotor durch das Getriebe an die Antriebsräder übertragen wird.

Vorzugsweise ist das Simulationsgerät derart eingerichtet, dass ein simuliertes Drehmoment des Verbrennnungsmotors aus den Fahrzeug-Ist-Kenngrößen:

- einer Getriebeübersetzung,
- dem Drehmoment und
- der Drehzahl des elektrischen Antriebsystems,

und einem aus Kenngrößen und/oder Kennfeldern abgeleiteten Referenzdrehmoment, und der jeweiligen simulierten Getriebestufe des Verbrennungsmotors bestimmt wird.

Weiter vorzugsweise ist das Simulationsgerät weiter derart eingerichtet, dass das simulierte Drehmoment des Verbrennungsmotors auf Werte zwischen 0 und 100 % begrenzt wird. Die 100 % des Simulierten Drehmoments entsprechen dabei dem maximalen Drehmoment des simulierten Verbrennungsmotors. Die Werte des Verbrennungsmotors können als Kenngrößen im Speicher des Simulationsgeräts abgelegt sein oder aus Kennfeldern abgeleitet werden.

Das Simulationsgerät ist bevorzugt derart eingerichtet, dass ein simuliertes Fahrerwunschmoment des Verbrennungsmotors aus der Fahrzeug-Ist-Kenngröße der Pedalstellung des Fahrpedals des Fahrers, der Getriebeübersetzung des elektrischen Antriebs, einem Ist-Fahrerwunschmoment aus einem Antriebsmomentkennfeld des elektrischen Antriebs und dem aus Kenngrößen und/oder Kennfeldern abgeleiteten Referenzdrehmoment aus bestimmt wird. Die Pedalstellung des Fahrpedals kann einen Wert zwischen 0 bis 100 % betragen, daraus kann je nach Fahrmodus des elektrischen Antriebsstrangs ein Ist-Fahrerwunschmoment in Abhängigkeit der absoluten Fahrzeuggeschwindigkeit durch lineare Interpolation des Antriebsmomentenkennfeldes bestimmt werden. Dabei sind auch negative Antriebsmomente möglich, denn im Gegensatz zum verbrennungsmotorischen Antriebsstrang kann das elektrische Antriebssystem rekuperieren und damit stark abbremsen.

Die eingangs genannte Aufgabe wird auch durch eine Antriebsstrangsteuerung eines elektrischen Antriebsystems eines Fahrzeugs, insbesondere eines elektrisch angetriebenen Nutzfahrzeugs, gelöst. Die Antriebsstrangsteuerung umfasst ein Motorsteuergerät zur Ansteuerung des elektrischen Antriebsystems, ein Bremssteuergerät zur Ansteuerung eines Bremssystems, wenigstens ein FAS-Steuergerät zur Ansteuerung wenigstens eines Fahrerassistenzsystems und zur Erzeugung von Eingriffssignalen zum für programmgesteuerten Eingriff in die Ansteuerung des elektrischen Antriebsystems und/oder des Bremssystems. Die Eingriffssignale werden in Abhängigkeit von Fahrzeug-Ist-Kenngrößen des elektrisch angetriebenen Fahrzeugs erzeugt. Weiter ist ein Fahrzeug-Bussystem zur Kommunikation der Steuergeräte und Systeme untereinander vorgesehen. Weiter ist ein erfindungsgemäßes Simulationsgerät in das Fahrzeug-Bussystem eingebunden, welches Simulationssignale für das Fahrerassistenzsystem in Abhängigkeit der Fahrzeug-Ist-Kenngrößen bereit stellt. Die Simulationssignale repräsentieren simulierte Kenngrößen eines wenigstens einen Verbrennungsmotor und ein Verbrennungsmotorgetriebe umfassenden verbrennungsmotorischen Antriebsstrangs und/oder simulierte Kenngrößen von Komponenten des verbrennungsmotorischen Antriebsstrangs.

Durch eine derartige Antriebsstrangsteuerung können FAS, welche zum Einsatz in mit einem verbrennungsmotorischen Antriebsstrang ausgestatteten Fahrzeug vorgesehen sind auch in einem elektrisch angetriebenen Fahrzeug umfassend ein elektrisches Antriebssystem eingesetzt werden, ohne die Funktionalität und/oder Sicherheit zu gefährden. Fehlende Signale aus dem nicht vorhandenen verbrennungsmotorischen Antriebsstrang werden durch das erfindungsgemäße Simulationsgerät bereitgestellt.

Weitere Einzelheiten und vorteilhafte Ausgestaltungen der Erfindung sind der nachfolgenden Beschreibung zu entnehmen, anhand derer Ausführungsbeispiele der Erfindung näher beschrieben und erläutert sind.

Es zeigen:

Figur 1: Ein Simulationsgerät eingebunden in ein Fahrzeugbussystem;

Figur 2: ein Kennfeld eines Verbrennungsmotors; und

Figur 3: ein Kennfeld eines elektrischen Antriebssystems.

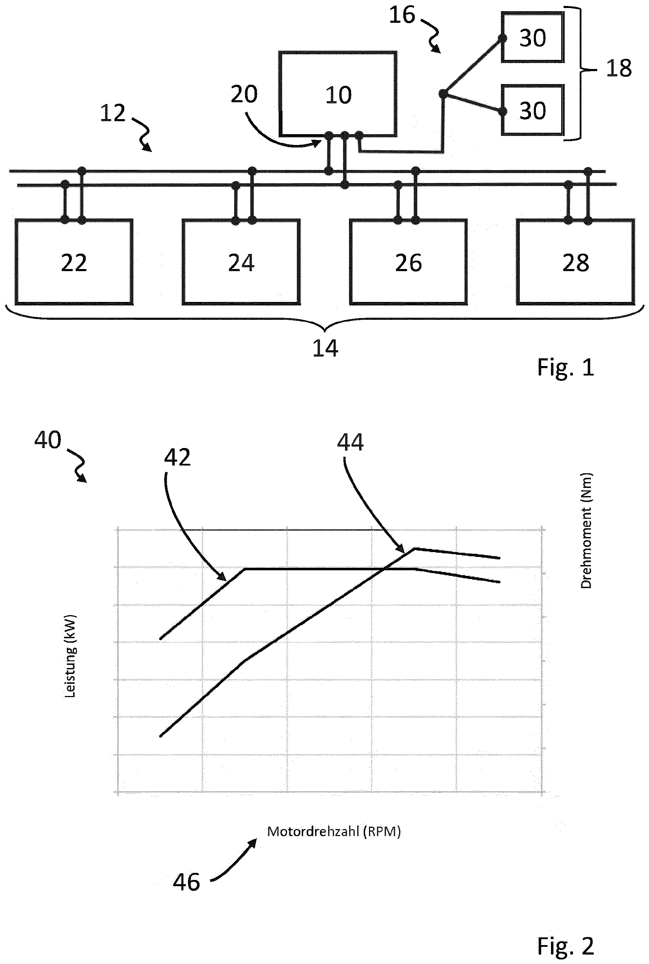

Figur 1 zeigt das Simulationsgerät 10 eingebunden in ein erstes Fahrzeug-Bussystem 12 mit weiteren Teilnehmern 14 des Bussystems 12. Das erste Fahrzeug-Bussystem 12 ist beispielhaft als CAN-Bus dargestellt, es sind auch andere Bussysteme denkbar. Weiterhin ist das Simulationsgerät 10 in ein zweites Fahrzeug-Bussystem 16 mit weiteren Teilnehmern 18 eingebunden. Das zweite Fahrzeugbussystem ist als LIN-Bus dargestellt, es könnte jedoch auch als zweiter CAN-Bus oder anderes Bus-System ausgeführt sein. Zur Einbindung des Simulationsgeräts 10 in Bussysteme 10,16 ist eine Kommunikationsschnittstelle 20 vorgesehen. Über die Kommunikationsschnittstelle 20 kann das Simulationsgerät 10 Signale der weiteren Teilnehmer 14,18 empfangen, sowie Signale senden.

Die Bussysteme 12,16 sind Bestandteile eines elektrisch angetriebenen Fahrzeugs (nicht dargestellt) und dessen Antriebsstrang bzw. elektrischen Antriebssystems (nicht dargestellt). Das elektrische Antriebssystem kann dabei ein Motorsteuergerät 22, ein Bremssteuergerät 24, ein FAS-Steuergerät 26, ein Fahrpedal 28, Sensoren 30, einen Elektromotor (nicht dargestellt) und eine Antriebsbatterie (nicht dargestellt) umfassen. Die Bussysteme 12,16 ermöglichen eine Kommunikation zwischen den Teilnehmern 14,18 untereinander und mit dem Simulationsgerät 10. Obwohl die Sensoren 30 als Teilnehmer 18 des zweiten Bussystems 16 dargestellt sind, könnten diese auch in das erste Bussystem 12 eingebunden sein. Die Sensoren 30 könnten zusätzliche Sensoren sein, welche nicht in einem elektrischen Antriebssystem benötigt werden, deren Kenngrößen jedoch vom Simulationsgerät 10 benötigt werden.

In Figur 2 ist ein Kennfeld 40 eines Verbrennungsmotors mit einem Drehmomentverlauf 42 und einem Leistungsverlauf 44 über der Motordrehzahl 46 gezeigt. Ein solches Kennfeld 40 ist im Speicher des Simulationsgeräts 10 abgelegt und wird zur Erzeugung der simulierten Kenngrößen der Simulationssignale herangezogen. Der Wertebereich der Motorleistung des Leistungsverlaufs 44 und des Motordrehmoments des Drehmomentverlaufs 42 entsprechen den üblichen Bereichen von Dieselmotoren für Nutzfahrzeugen, übliche Wertebereiche sind 20 - 180 kW und 200 - 700 Nm.

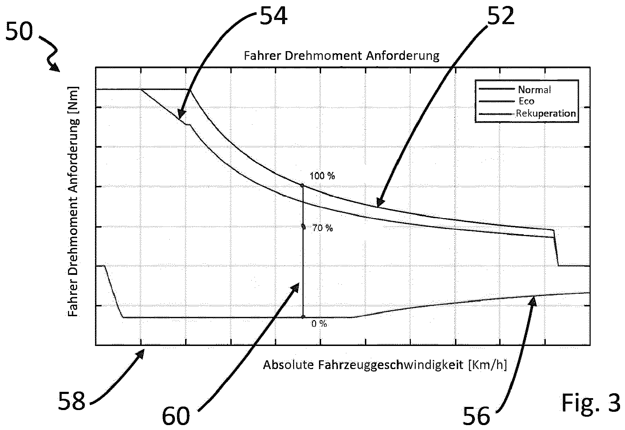

In Figur 3 ist ein Antriebsmomentenkennfeld 50 des elektrischen Antriebssystems mit Kennlinien der Antriebsmomente verschiedener Fahrmodi gezeigt. Die Fahrmodi umfassen den Modus normal 52 und den Modus Eco 54. Weiter ist eine Kurve des Bremsmomentverlaufs 56 für die Rekuperation gezeigt. Die Kurven 52, 54, 56, verlaufen in Abhängigkeit der absoluten Fahrzeuggeschwindigkeit 58 des elektrisch angetriebenen Fahrzeugs. Die Fahrzeuggeschwindigkeit 58 liegt in für Nutzfahrzeugen üblichen Bereichen von 0 bis 120 km/h.

Das Simulationsgerät 10 ist insbesondere dazu eingerichtet simulierten Kenngrößen eines verbrennungsmotorischen Antriebsstrangs zu erzeugen, insbesondere: Die Getriebestufe *Gear,* die Drehzahl des Verbrennungsmotors *EngineSpeed,* das prozentuale Drehmoment des Verbrennungsmotors EngineTorquePercent und das prozentuale Fahrerwunschmoment *DriverTorqueDemandPercent.* Dabei können die nachfolgend beschriebenen Schritte zur Erzeugung der simulierten Kenngrößen periodisch wiederholt werden.

1. Zunächst wird die simulierte Kenngröße Getriebestufe - *Gear* - bestimmt. Dazu wird eine mittlere Geschwindigkeit der Antriebsräder *v_Axle,* aus Drehgeschwindigkeit und Größe der der Antriebsräder *U_Tyre,* bestimmt. Dabei werden die Fahrzeug-Ist-Kenngrößen des Fahrzeugs wie Getriebeübersetzung und Abrollumfang der Antriebsräder sowie Kenngrößen des Originalfahrzeugs wie Getriebe- und Differentialübersetzung berücksichtigt. Die Drehgeschwindigkeit der Antriebsräder könnte über die Kommunikationsschnittstelle 20 vom FAS-Steuergerät 26 über das erste Bussystem 12 bereitgestellt werden. Daraus ergeben sich Geschwindigkeitsschwellwerte für den Schaltvorgang in die nächsthöhere Getriebestufe, bzw. Geschwindigkeitsbereiche für eine bestimmte Fahrstufe. Dies könnte als eine Tabelle hinterlegt sein.

Die Geschwindigkeitsschwellwerte zum Herunterschalten in die niedrigere Getriebestufe von *Gear* sind jeweils 5 km/h geringer als beim Hochschalten. Schematisch folgt das Schaltschema einer Hysterese.

2. Danach wird die simulierte Drehzahl des Verbrennungsmotors - *EngineSpeed* - gemäß der folgenden Gleichung bestimmt:

$$EngineSpeed = \frac{v\_Axle}{U\_Tyre * i\_total(Gear)}$$

*i_total(Gear)* bezeichnet dabei das Produkt aus der Differentialübersetzung des verbrennungsmotorischen Antriebsstrangs und der Getriebeübersetzung der simulierten eingelegten Getriebestufe *Gear.* Wobei die Getriebestufe nach 1. erzeugt wird und die Differentialübersetzung als Kenngröße und/oder Kennfeld im Speicher des Simulationsgeräts 10 hinterlegt sind.

Die simulierte Drehzahl des Verbrennungsmotors wird durch das erfindungsgemäße Simulationsgerät 10 auf eine minimale Drehzahl von beispielsweise 750 1/min begrenzt. Dieser Wert entspricht der Leerlaufdrehzahl des Verbrennungsmotors eines Nutzfahrzeugs und ist beispielsweise als Kenngröße hinterlegt oder aus dem Kennfeld 40 ableitbar.

3. Danach wird bei einem simulierten Wechsel der Getriebestufe *Gear* die simulierte Drehzahl *EngineSpeed* des Verbrennungsmotors für einen vorgegebenen Zeitraum auf die minimale Drehzahl gesetzt. Dies geschieht unabhängig davon, was unter 1. und 2. berechnet wurde. Beispielsweise ist für den vorgegebenen Zeitraum eine Kenngrößen hinterlegt, die einer Schaltzeit eines Schaltvorgangs des verbrennungsmotorischen Getriebes entspricht. Üblicherweise liegen Schaltzeiten im Bereich von 0,4 bis 1,5 s. Es wäre denkbar verschiedene Schaltzeiten im Speicher des Simulationsgeräts 10 als Kenngrößen zu hinterlegen.

4. Zur Bestimmung des simulierten, prozentualen Drehmoments des Verbrennungsmotors - *EngineTorquePercent* - ist im Simulationsgerät 10 folgende Gleichung hinterlegt, bei der Fahrzeug-Ist-Kenngrößen, beispielsweise bereitgestellt aus dem Motorsteuergerät 22, simulierte Kenngrößen und Kenngrößen aus dem Speicher des Simulationsgeräts 10 mit einfließen:

$$EngineTorquePercent =$$

$$\frac{MotorTorqueLeft * sign(MotorSpeedLeft) + MotorTorqueRight * sign(MotorSpeedRight)}{TorqueReference}$$

$$* \frac{i\_Planet}{i\_total(Gear)} * 100\%$$

In vorliegendem Beispiel sind zwei Elektromotoren an der Antriebsachse im elektrischen Antriebssystem, mit je einem Motor rechts und links, vorgesehen. Im Einzelnen gelten folgende Bezeichnungen für die obige Formel:

- *sign* ist eine mathematische Funktion, welches das Vorzeichen ihres Arguments zurückgibt.
- *MotorTorque* das Fahrzeug-Ist-Drehmoment des linken bzw. rechten Elektromotors der Antriebsachse, dies kann vom Motorsteuergerät 22 bereitgestellt werden.
- *MotorSpeed* die Fahrzeug-Ist-Drehzahl des linken bzw. rechten Elektromotors Antriebsachse, dies kann vom Motorsteuergerät 22 bereitgestellt werden.
- *TorqueReference* das Referenzdrehmoment des Verbrennungsmotors, beispielsweise aus dem Kennfeld 40; im vorliegenden Beispiel das maximale Drehmoment des Verbrennungsmotors des Kennfeldes 40 aus Fig. 2 an dessen Kurbelwelle.
- *i_Planet* die Getriebeübersetzung des elektrischen Antriebssystems zwischen dem Elektromotor und dem Antriebsrad, wobei in dieser Ausführungsform ein Planetengetriebe benutzt wird.
- *i_total* nach der Berechnung unter Punkt 3.

Die bestimmte Kenngröße des prozentualen Drehmoments des Verbrennungsmotors - *EngineTorquePercent* wird anschließend auf Werte zwischen 0 und 100 % entsprechend des Wertes *TorqueReference* begrenzt, selbst wenn sich rechnerisch höhere oder niedrigere Werte ergeben sollten.

5. Zur Bestimmung des simulierten, prozentualen Fahrerwunschmoments *DriverTorqueDemandPercent* wird folgende Gleichung vom Simulationsgerät herangezogen:

$$DriverTorqueDemandPercent = \frac{M\_Driver * i\_Planet}{TorqueReference * i\_total(Gear)} * 100\%$$

Dabei gelten dieselben Bezeichnungen wie unter 4. Die Bezeichnung M_Driver stellt das Ist-Fahrerwunschmoment im elektrischen Antriebsstrang dar. Dieses ist ein Zusammenhang aus dem Absolutbetrag der Ist-Fahrzeuggeschwindigkeit, beispielsweise v_Axle und der Fahrpedalposition zwischen 0 und 100 %.

Das Ist-Fahrerwunschmoment M_Driver lässt sich aus dem in Figur 3 gezeigten Antriebsmomentenkennfeld 50 folgendermaßen bestimmen:

a. Die in Figur 3 gezeigte Kurve 52 zeigt das maximale Antriebsmoment, welches im Normal-Fahrmodus erreicht werden kann; falls der Modus Eco gewählt wurde, bestimmt sich das maximale Antriebsmoment entsprechend der Kurve 54. Die Kurve 56 kennzeichnet das minimale Antriebsmoment in den negativen Bereich hinein, da das elektrische Antriebssystem auch die Möglichkeit zur Rekuperation bietet. Dies ist ähnlich einer Motorbremse eines verbrennungsmotorischen Antriebsstrangs. Die Kurven 52, 54 und 56 sind jeweils in Abhängigkeit der Fahrzeuggeschwindigkeit 58.

b. Die senkrechte Linie 60 im Kennfeld 50 zeigt ein Zahlenbeispiel:

i. Die absoulute Fahrzeug-Geschwindigkeit beträgt etwa 50 km/h. Dabei beträgt das maximale Antriebsmoment entsprechend Kurve 52 (Fahrpedalstellung 100 %) etwa 200 Nm und das maximale Rekuperationsmoment (Fahrpedalstellung 0 %) beträgt -130 Nm.

ii. Das Fahrerwunschmoment ergibt sich nun durch lineare Interpolation zwischen diesen beiden Extremwerten mit der tatsächlichen Fahrpedalstellung. Im Beispiel führt eine Fahrpedalstellung von 70 % zu einem Fahrerwunschmoment von etwa 100 Nm. Dieser Wert wird in der Gleichung unter 8. verwendet.

iii. Wenn sich die Geschwindigkeit des Fahrzeugs ändert, folgen die beiden genannten Extremwerte den jeweiligen Linien. Die Interpolation wird mit den jeweils aktuellen Werten durchgeführt.

Durch ein derartig eingerichtetes Simulationsgerät 10 können bisherige für verbrennungsmotorisch angetriebene Fahrzeuge vorgesehene FAS für elektrisch angetriebenen Fahrzeugen bereitgestellt werden. Ein Simulationsgerät ermöglicht die FAS kostengünstig und ohne hohen Entwicklungsaufwand zur Verfügung zu stellen, besonders, wenn das Simulationsgerät 10 in einer Antriebsstrangsteuerung eingesetzt wird.

**Patentansprüche**

1. Simulationsgerät (10) zur Einbindung in wenigstens ein Fahrzeug-Bussystem (12, 16) eines ein elektrisches Antriebssystem umfassenden Fahrzeugs, insbesondere eines elektrisch angetriebenen Nutzfahrzeugs,
   wobei das Simulationsgerät (10) zur Erzeugung von Simulationssignalen derart eingerichtet ist, dass die Simulationssignale

   - in Abhängigkeit von Fahrzeug-Ist-Kenngrößen des elektrisch angetriebenen Fahrzeugs erzeugt werden,
   - simulierte Kenngrößen eines wenigstens einen Verbrennungsmotor und ein Verbrennungsmotorgetriebe umfassenden verbrennungsmotorischen Antriebsstrang und/oder simulierte Kenngrößen von Komponenten des verbrennungsmotorischen Antriebsstrangs repräsentieren, und
   - zur Verarbeitung durch wenigstens ein FAS-Steuergerät eines Fahrerassistenzsystems (FAS) vorgesehen sind.

2. Simulationsgerät (10) nach Anspruch 1, wobei das Simulationsgerät (10) weiter derart eingerichtet ist, dass es als Fahrzeug-Ist-Kenngrößen Signale und Kenngrößen verarbeitet, die repräsentieren

   - eine Größe der Räder des elektrisch angetriebenen Fahrzeugs,
   - eine Geschwindigkeit des elektrisch angetriebenen Fahrzeugs,
   - eine Drehgeschwindigkeit der Rädern des elektrisch angetriebenen Fahrzeugs,
   - eine Drehzahl des elektrischen Antriebsystems,
   - ein Drehmoment des elektrischen Antriebsystems, und/oder
   - Leistungsaufnahme des elektrischen Antriebsystems.

3. Simulationsgerät (10) nach Anspruch 1 oder 2, wobei das Simulationsgerät (10) weiter derart eingerichtet ist, dass die simulierten Kenngrößen der Simulationssignale repräsentieren

   - eine simulierte Motordrehzahl des Verbrennungsmotors,
   - eine simulierte Getriebestufe des Verbrennungsmotorgetriebes,
   - ein simuliertes Motordrehmoment des Verbrennungsmotors und/oder
   - ein simuliertes Ausgangsdrehmoment des vom Verbrennungsmotor angetriebenen Antriebsstrangs.

4. Simulationsgerät (10) nach Anspruch 1, 2 oder 3, weiter derart eingerichtet ist, dass die simulierten Kenngrößen auch in Abhängigkeit von FAS-Signalen, die von dem wenigstens einen FAS erzeugt wurden, erzeugt werden.

5. Simulationsgerät (10) nach wenigstens einem der vorhergehenden Ansprüche, wobei das Simulationsgerät (10) weiter derart eingerichtet ist, dass es als Fahrzeug-Ist-Kenngrößen auch Signale und Kenngrößen verarbeitet, die die jeweilige Pedalstellung des Fahrpedals des Fahrers repräsentieren, und wobei als Simulationssignal auch eine Kenngröße erzeugt wird, die ein simuliertes Fahrerwunschmoment des Verbrennungsmotors oder des verbrennungsmotorischen Antriebsstrangs repräsentiert.

6. Simulationsgerät (10) nach wenigstens einem der vorhergehenden Ansprüche, wobei das Simulationsgerät (10) eine Schnittstelle zur Einbindung in wenigstens ein Fahrzeug-Bussystem (12, 16) aufweist, wobei das Simulationsgerät (10) weiter derart eingerichtet ist, dass das Simulationsgerät (10) über die Schnittstelle die Fahrzeug Ist-Kenngrößen empfängt und die Simulationssignale an das FAS-Steuergerät sendet.

7. Simulationsgerät (10) nach wenigstens einem der vorhergehenden Ansprüche, wobei das Simulationsgerät (10) weiter derart eingerichtet ist, dass das Simulationsgerät (10) einen Speicher umfasst, in dem Kenngrößen und/oder Kennfelder des verbrennungsmotorischen Antriebsstrangs und/oder von dessen Komponenten hinterlegt sind und dass die Simulationssignale auch in Abhängigkeit der Kenngrößen und/oder Kennfelder erzeugt werden.

8.  Simulationsgerät (10) nach wenigstens einem der vorhergehenden Ansprüche, wobei das Simulationsgerät (10) weiter derart eingerichtet ist, dass aus der jeweiligen Fahrzeuggeschwindigkeit eine simulierte Getriebestufe des Verbrennungsmotorgetriebes bestimmt wird.

9.  Simulationsgerät (10) nach Anspruch 8, wobei das Simulationsgerät (10) weiter derart eingerichtet ist, dass aus der jeweiligen Fahrzeuggeschwindigkeit und der jeweils bestimmten simulierten Getriebestufe eine simulierte Drehzahl des Verbrennungsmotors bestimmt wird.

10. Simulationsgerät (10) nach Anspruch 9, wobei das Simulationsgerät (10) weiter derart eingerichtet ist, dass dann, wenn ein Wechsel der Getriebestufte simuliert wird, die simulierte Drehzahl für einen vorgegebenen Zeitraum eine minimale Drehzahl repräsentiert.

11. Simulationsgerät (10) nach einem der Ansprüche 9 oder 10, wobei das Simulationsgerät (10) weiter derart eingerichtet ist, dass ein simuliertes Drehmoment des Verbrennungsmotors aus den Fahrzeug Ist-Kenngrößen:

    - einer Getriebeübersetzung,
    - dem Drehmoment und
    - der Drehzahl des elektrischen Antriebsystems,

    und einem aus Kenngrößen und/oder Kennfeldern abgeleiteten Referenzdrehmoment, und der jeweiligen simulierten Getriebestufe des Verbrennungsmotors bestimmt wird.

12. Simulationsgerät (10) nach Anspruch 11, wobei das Simulationsgerät (10) weiter derart eingerichtet ist, dass das simulierte Drehmoment des Verbrennungsmotors auf Werte zwischen 0 und 100 % begrenzt wird.

13. Simulationsgerät (10) nach einem der Ansprüche 8 bis 12, wobei das Simulationsgerät (10) weiter derart eingerichtet ist, dass ein simuliertes Fahrerwunschmoment des Verbrennungsmotors aus der Fahrzeug-Ist-Kenngröße der Pedalstellung des Fahrpedals des Fahrers, der Getriebeübersetzung des elektrischen Antriebs, einem Ist-Fahrerwunschmoment aus einem Antriebsmomentkennfeld des elektrischen Antriebs und dem aus Kenngrößen und/oder Kennfeldern abgeleiteten Referenzdrehmoment aus bestimmt wird.

14. Antriebsstrangsteuerung eines elektrischen Antriebsystems eines Fahrzeugs, insbesondere eines elektrisch angetriebenen Nutzfahrzeugs,

    mit einem Motorsteuergerät zur Ansteuerung des elektrischen Antriebsystems,
    mit einem Bremssteuergerät zur Ansteuerung eines Bremssystems,
    mit wenigstens einem FAS-Steuergerät zur Ansteuerung wenigstens eines Fahrerassistenzsystems und zur Erzeugung von Eingriffssignalen zum für programmgesteuerten Eingriff in die Ansteuerung des elektrischen Antriebsystems und/oder des Bremssystems, wobei die Eingriffssignale
    in Abhängigkeit von Fahrzeug-Ist-Kenngrößen des elektrisch angetriebenen Fahrzeugs erzeugt werden, mit einem Fahrzeug-Bussystem (12, 16) zur Kommunikation der Steuergeräte und Systeme untereinander, **dadurch gekennzeichnet, dass** ein Simulationsgerät (10) nach einem der vorhergehenden Ansprüche in das Fahrzeug-Bussystem (12, 16) eingebunden ist, welches Simulationssignale für das Fahrerassistenzsystem in Abhängigkeit der Fahrzeug-Ist-Kenngrößen bereit stellt, welche simulierte Kenngrößen eines wenigstens einen Verbrennungsmotor und ein Verbrennungsmotorgetriebe umfassenden verbrennungsmotorischen Antriebsstrangs und/oder simulierte Kenngrößen von Komponenten des verbrennungsmotorischen Antriebsstrangs repräsentieren.

16

30

18

10

20

12

30

22    24    26    28

14

Fig. 1

40

42    44

Leistung (kW)

Drehmoment (Nm)

Motordrehzahl (RPM)

46

Fig. 2

50

54

52

Fahrer Drehmoment Anforderung

Fahrer Drehmoment Anforderung [Nm]

| Normal |
| Eco |
| Rekuperation |

100 %

70 %

0 %

Absolute Fahrzeuggeschwindigkeit [Km/h]

58

60

56

Fig. 3

Europäisches Patentamt
European Patent Office
Office européen des brevets

# EUROPÄISCHER RECHERCHENBERICHT

Nummer der Anmeldung

EP 23 21 5524

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,P | WO 2023/006798 A1 (E R3VOLT GMBH [DE]) 2. Februar 2023 (2023-02-02) * das ganze Dokument * ----- | 1-7,14 | INV. B60L15/20 B60W40/12 G01R31/00 |
| Y | Scott Christopher: "Some of the challenges to your modern EV conversion – CANbus – Harden Electric", , 11. Mai 2020 (2020-05-11), XP055973327, Gefunden im Internet: URL:https://www.hardenelectric.com.au/canbus-issues/ [gefunden am 2022-10-20] * das ganze Dokument * ----- | 1-14 | G06F30/15 B60K1/00 B60L3/00 |
| Y | US 2022/063494 A1 (DUO' JONATHAN [IT] ET AL) 3. März 2022 (2022-03-03) * Zusammenfassung * * Absatz [0016] – Absatz [0267]; Ansprüche 18-38; Abbildung 1a * ----- | 1-14 | |
| Y | US 2022/041066 A1 (ISAMI YOICHIRO [JP] ET AL) 10. Februar 2022 (2022-02-10) * Zusammenfassung * * Absatz [0011] – Absatz [0109] * ----- | 1-14 | RECHERCHIERTE SACHGEBIETE (IPC) B60L G01R G06F B60W B60K |

Der vorliegende Recherchenbericht wurde für alle Patentansprüche erstellt

| Recherchenort | Abschlußdatum der Recherche | Prüfer |
|---|---|---|
| München | 23. April 2024 | Salsa, Francesco |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 21 5524

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-04-2024

| Im Recherchenbericht angeführtes Patentdokument | Datum der Veröffentlichung | Mitglied(er) der Patentfamilie | Datum der Veröffentlichung |
|---|---|---|---|
| WO 2023006798 A1 | 02-02-2023 | DE 102021119579 A1 | 02-02-2023 |
| | | WO 2023006798 A1 | 02-02-2023 |
| US 2022063494 A1 | 03-03-2022 | CN 113165531 A | 23-07-2021 |
| | | EP 3877204 A1 | 15-09-2021 |
| | | US 2022063494 A1 | 03-03-2022 |
| | | WO 2020095280 A1 | 14-05-2020 |
| US 2022041066 A1 | 10-02-2022 | CN 114056115 A | 18-02-2022 |
| | | DE 102021119980 A1 | 10-02-2022 |
| | | JP 7294272 B2 | 20-06-2023 |
| | | JP 2022030868 A | 18-02-2022 |
| | | US 2022041066 A1 | 10-02-2022 |

EPO FORM P0461

Für nähere Einzelheiten zu diesem Anhang : siehe Amtsblatt des Europäischen Patentamts, Nr.12/82